# EUROPEAN PATENT SPECIFICATION

(11) **EP 1 434 261 B1**
(45) Date of publication and mention of the grant of the patent: **31.03.2010**
(21) Application number: 02765504.2
(22) Date of filing: 12.09.2002
(51) Int. Cl.: H01L 21/60, H05K 3/32

(54) **CIRCUIT DEVICE MOUNTING METHOD AND PRESS**
VERFAHREN UND PRESSE ZUR MONTAGE EINER SCHALTUNG
PROCEDE ET PRESSE DE MONTAGE DE CIRCUITS

(30) Priority: 12.09.2001 JP 2001276806; 12.09.2001 JP 2001276819
(43) Date of publication of application: 30.06.2004
(73) Proprietor: NIKKISO CO., LTD., Shibuya-ku Tokyo 150-8677 (JP)
(72) Inventor: MATSUNO, Hisao, c/o NIKKISO CO., LTD., Shibuya-ku, Tokyo 150-8677 (JP); OSUGI, Kenjiro, c/o NIKKISO CO., LTD., Higashimurayama-shi, Tokyo 189-8520 (JP)
(74) Representative: Grosse - Schumacher - Knauer - von Hirschhausen
(86) International application number: PCT/JP2002/009342
(87) International publication number: WO 2003/025997

(56) References cited:
- GB-A- 1 376 132
- JP-A- 9 324 127
- JP-A- 10 256 311
- JP-A- 63 305 520
- JP-A- 2000 068 633
- JP-A- 2001 230 528
- US-A- 4 594 472

## Description

### Technical Field

The present invention relates to a method of mounting a circuit element such as an integrated circuit chip onto a substrate, and a pressure device suitable for the mounting the circuit element.

### Background Art

As a method of mounting a circuit element onto a substrate, there is known a method in which an adhesive film is disposed between the substrate and the circuit element and the circuit element is pressed toward the substrate and then heated to accomplish pressure mounting. As the adhesive film, a thermosetting anisotropic conductive film may be used, and in this case, bonding and wiring of the element can be carried out at the same time. This process will be described. First, the anisotropic conductive film is disposed at a circuit element mounting position on the substrate, and the circuit element is then disposed on the film. Since surfaces of the anisotropic conductive film have adhesive properties, the circuit element is provisionally fixed or bonded by pressing the circuit element slightly at the time of the disposition of the element. Electrodes which are called bumps for electrical connection protrude from the back surface of the circuit element to the outside. Wiring is arranged on the substrate on which the element is disposed, at positions opposite to the bumps. When the circuit element is pressed in the state where it is disposed on the substrate, the anisotropic conductive film between the bumps and the wiring is further pressed and thereby brought into a conductive state, because the bumps and the wiring protrude from the surfaces of the circuit element and the substrate. As will be understood from the above, the anisotropic conductive film has properties that the pressed and compressed portions thereof are brought into the conductive state. Then, heating is applied, so that the anisotropic conductive film bonds the substrate to the circuit element, whereby actual bonding is achieved.

During the actual bonding, the circuit element is pressed by a pressing rod having a tip area substantially equal to an area of the surface of the element which should be pressed, and a heating element is disposed in the pressing rod to simultaneously perform the heating.

As described above, in a conventional apparatus, the pressing is carried out by the tip of the hard pressing rod, and in a case where the thickness of an adhesive film such as the anisotropic conductive film is not uniform, the circuit element is disposed in an inclined state. In consequence, the whole cannot be pressed under an equal pressure, which causes a problem that electrical connection defects sometimes occur.

Furthermore, the adhesive film protrudes sideways as a result of the pressing, and therefore, in consideration of this fact, it is necessary to dispose the adjacent circuit elements apart from each other. In consequence, there is a problem that mounting density cannot be increased.

Moreover, the thickness of the circuit element depends on its type, and a stroke of the pressing rod changes in accordance with the thickness. Therefore, the circuit elements have to be pressed and heated one by one, which causes a problem that many process time is required.

In addition, in order to prevent heat from transferring to an adjacent non-pressure bonded circuit element and the corresponding adhesive film during the heating for the bonding, the circuit elements need to be disposed apart from each other. In consequence, there is a problem that the mounting density cannot be increased.

JP-A-2001 230 528 discloses a method of mounting a circuit element on a substrate.

### Disclosure of the Invention

The present invention has been developed in consideration of the above-described problems. A first object of the present invention is to increase a mounting density of circuit elements, and a second object is to reduce steps required for the mounting.

To solve the above-described problems, according to the present invention, there is provided a method of mounting a circuit element as defined in claim 1.

Owing to the application of pressure via the flexible layer, an equal pressure can be applied to the circuit element, and the element can be bonded more securely. Even when a plurality of circuit elements have differences in thickness, these differences are absorbed by the flexible layer, and therefore the plurality of elements can be pressed simultaneously.

Furthermore, when a thermosetting resin film is used as the adhesive film, heating can be carried out by the use of the pressing mold simultaneously with the pressing to harden a resin to thereby accomplish the bonding. Since the plurality of circuit elements can be pressed and heated simultaneously as described above, a thermal influence on an unheated adjacent circuit element and adhesive sheet does not have to be considered. This fact can enable a close arrangement of the elements, which can increase mounting density.

Flexibility, thickness and the like of the flexible layer are preferably set by isotropic pressing where the flexible layer is brought into close contact with the surface opposite to the pressing mold and the side surfaces of the superposed and integrated adhesive film and circuit element and are then pressed from the whole periphery of the flexible layer. By performing the isotropic pressing, the protrusion of the anisotropic conductive film from the sides can be prevented. This constitution enables the close arrangement of integrated circuit chips, with the result that the mounting density can be increased.

Moreover, the flexible layer can be obtained by mixing a base material having flexibility with a material which is to be added to the base material to improve thermal conductivity of the flexible layer. For example, the flexible layer may be obtained by selecting a rubber as the base material for the flexible layer, and then mixing the rubber with fine particles or fine fibers of carbon.

When the thermal conductivity of the flexible layer is improved, the adhesive film is heated more quickly, thereby shortening the process.

### Brief Description of the Drawings

FIG. 1 is an explanatory view of a method of mounting an integrated circuit chip in an embodiment of the present invention;
FIG. 2 is a diagram showing a schematic constitution of a pressure device for use in the mounting of the integrated circuit chip;
FIG. 3 is a diagram showing heat transfer characteristics of various rubber materials;
FIG. 4 is an explanatory view of one problem in the mounting of the integrated circuit chip;
FIG. 5 is an explanatory view of another problem in the mounting of the integrated circuit chip;
FIG. 6 is an explanatory view of characteristics of the mounting method in the embodiment of the present invention; and
FIG. 7 is a diagram showing the schematic constitution of another pressure device for use in the mounting of the integrated circuit chip.

### Best Mode for Carrying out the Invention

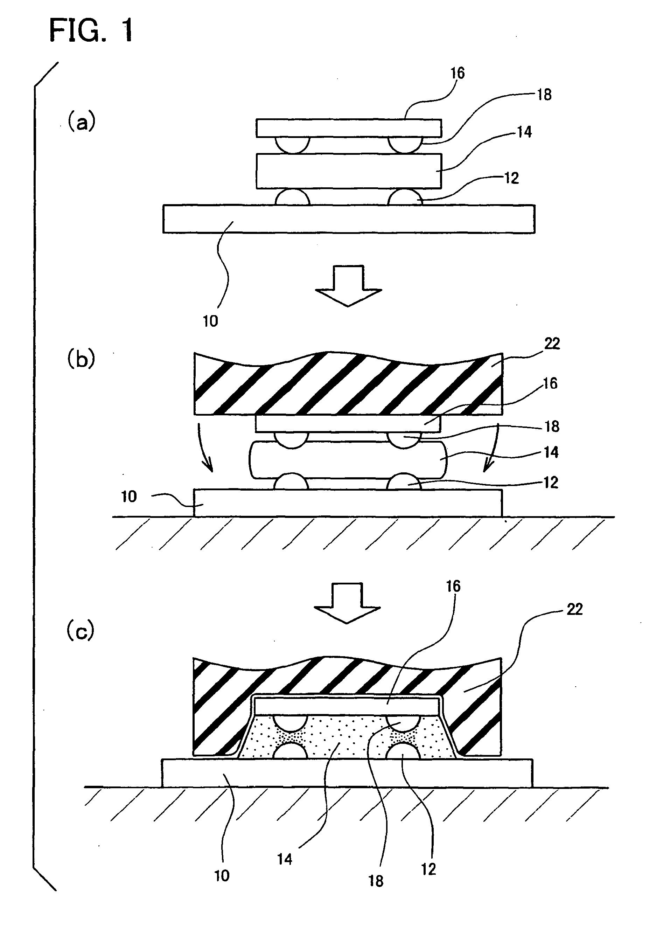

An embodiment of the present invention will hereinafter be described with reference to the drawings. FIG. 1 is an explanatory view of a method of mounting circuit elements such as an integrated circuit chip of the present embodiment. As shown in FIG. 1(a), wiring 12 is formed on the surface of a substrate 10 in a predetermined pattern. A thermosetting anisotropic conductive film 14 for bonding and wiring and a circuit element 16 are disposed at predetermined positions on the substrate 10. Ridges called bumps 18 constituting electrical contacts are disposed on the surface (lower surface in the drawing) of the circuit element 16 opposite to the substrate 10. The wiring 12 is positioned opposite to the bumps 18 via the anisotropic conductive film 14. In other words, positions where the wiring 12 is to be disposed are determined based on the mounting position of the circuit element 16.

Next, as shown in FIG. 1(b), a flexible layer 22 disposed on a portion of a pressing mold which contacts the circuit element 16 or the like is brought into contact with the surface of the circuit element 16. Moreover, the pressing mold is further moved in a stroke to draw the flexible layer 22 sideways toward the circuit element 16 or the anisotropic conductive film 14 as shown by arrows in the drawing.

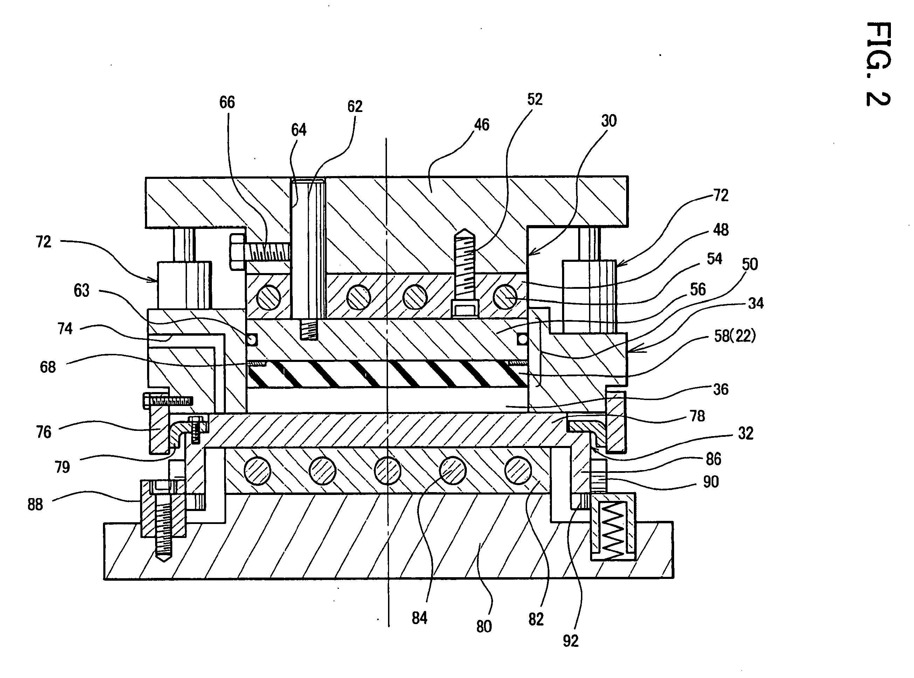

As shown in FIG. 1(c), the circuit element 16 and anisotropic conductive film 14 constituting pressing objects are integrally pressed at the periphery, from above and sides in the drawing, and so-called isotropic pressing is carried out. As described above, the wiring 12 and bumps 18 are raised from the surfaces where they are disposed. When pressed, portions of the anisotropic conductive film 14 held between the wiring 12 and the bumps 18 are further compressed, the compressed portions have conductivity, and a conductive state is achieved between the wiring 12 and the bumps 18. The pressing mold includes heaters 54, 84 (see FIG. 2), and the anisotropic conductive film 14 is hardened by heat from the heaters to bond the circuit element 16.

FIG. 2 is a diagram showing a schematic constitution of a pressure device for bonding the integrated circuit chip. In the device, an upper mold 30, a lower mold 32, and a side mold 34 form a cavity 36 in which the substrate 10, circuit element 16 and the like constituting the pressing objects are to be disposed. The upper mold 30 is moved toward the lower mold 32 to apply pressure to the pressing objects in the cavity 36. That is, the upper mold 30 and lower mold 32 hold and press the substrate 10 and the anisotropic conductive film 14 and circuit element 16 superposed/laid on the substrate.

The upper mold 30 includes an upper mold main body 46 connected to a fluid pressure piston (not shown), and further a heating plate 48 and pressing pad 50 are fixed to the tip of the upper mold main body 46. The heating plate 48 is fixed to the upper mold main body 46 by a pierced bolt 52. The heater 54 is disposed inside. The temperature of the heating plate 48 rises as a result of heating by the heater 54, and the heat is transferred to the pressing objects via the pressing pad 50.

The pressing pad 50 has a multilayered structure including a back plate 56 and a rubber plate 58 bonded/fixed to each other. The back plate 56 is screwed/connected to a hanging pin 62, and the hanging pin 62 is inserted in a hole 64 formed in the upper mold main body 46 and fixed by a bolt 66 from the side. An O ring 63 for mutually sealing the molds is disposed in a portion of the side surface of the back plate 56 which contacts the side mold 34 in order to reduce the pressure in the cavity 36. The rubber plate 58 corresponds to the flexible layer 22 shown in FIG. 1, and has such a flexibility that the circuit element 16 or the anisotropic conductive film 14 can be pressed from the periphery. Due to its elasticity, the rubber plate 58 returns to a shown flat plate shape when released from a pressed state after bonding the circuit element, and the next pressing can be similarly carried out.

The rubber plate 58 functions to absorb deflection and to press in an overall uniform manner in a case where the upper surface of the circuit element 16 laid on the substrate 10 is not parallel to the substrate or the like. For example, when the upper surface of the circuit element 16 is not parallel to the tip surface of the upper mold 30, and when no rubber plate 58 is disposed and the upper mold 30 is formed to be rigid, a large pressure is applied to a highest portion of the circuit element 16. When the rubber plate 58 is disposed, inclination of the circuit element 16 can be absorbed. That is, the rubber plate 58 functions as a flexible layer to such an extent that the inclination of the circuit element 16 can be absorbed. Therefore, the flexible layer may be constituted of another material instead of the rubber as long as the layer has required flexibility. In the present embodiment, the rubber plate 58 is formed of a silicon rubber, especially in consideration of resistance to heat, but it is also possible to use another type of rubber and the other materials described above.

A backup ring 68 is disposed on the edge of the surface of the rubber plate 58 which contacts the back plate 56. The backup ring 68 is shaped so as to fill in an annular shoulder portion formed in the edge of the rubber plate 58. The outer peripheral surface of the backup ring abuts on the inner surface of the side mold 34. This inhibits the rubber plate 58 from leaking out of a gap between the molds by the pressure. A portion of the edge of the rubber plate 58 is hollowed to form the shoulder portion, the backup ring 68 is disposed so as to fill in this shoulder portion, and accordingly the rubber plate 58 itself to which the pressure is applied applies a force to press the backup ring 68 toward the side mold 34 from behind the ring. This can achieve even firmer sealing.

The side mold 34 is suspended/supported by the upper mold 30 via four fluid pressure cylinders 72. The side mold 34 has an annular shape so as to surround the sides of the pressing pad 50 and cavity 36. The fluid pressure cylinders 72 press the side mold 34 toward the lower mold 32 to closely bond these at a pressing/molding time. At this time, the fluid pressure cylinders 72 react to push the upper mold 30 upwards, but a pressing force for pushing the upper mold 30 downwards is sufficiently larger than forces of the fluid pressure cylinders 72, and the pressing force does not substantially decrease. An exhaust hole 74 for exhausting a gas or the like to the outside of the cavity 36 is formed in the side mold 34. An annular seal frame 76 is fixed along the outer periphery of the side mold 34. The seal frame 76 forms a seal structure for sealing a space substantially surrounded with the molds, including the cavity 36, from the outside together with an abutment piece 79.

The lower mold 32 has a lower mold main body 78 on which the substrate 10 is to be laid, and the lower mold main body 78 is laid on a heating plate 82 fixed onto a table 80. The heater 84 is disposed inside the heating plate 82, and the heat produced by the heater 84 is transferred to the substrate 10 and anisotropic conductive film 14 via the heating plate 82 and lower mold main body 78. The annular abutment piece 79 abutting on the inner surface of the seal frame 76 is fixed to the side of the lower mold main body 78.

Leg portions 86 directed downwards are formed in four corners of the lower mold main body 78. The lower mold main body 78 and leg portions 86 bestride the heating plate 82 of the table 80. A vertical roller 90 which abuts on the upper surface of a rail 88 formed on the table 80 and which defines a vertical position of the lower mold 32 in FIG. 2 is rotatably supported by the leg portions 86. Furthermore, a horizontal roller 92 which abuts on the side surface of the rail 88 and which defines a horizontal position of the lower mold 32 in FIG. 2 is rotatably supported by the leg portions 86.

As described above, the heat from the heating plate 48 disposed in the upper mold 30 is transferred to a heating object via the rubber plate 58. The rubber is generally a material having a comparatively bad heat transfer characteristic, and there is a possibility that the portion of the rubber plate 58 will obstruct the heat transfer from the heating plate 48. In the present embodiment, a rubber material which more satisfactorily transfers the heat is used as the material of the rubber plate 58, as described later.

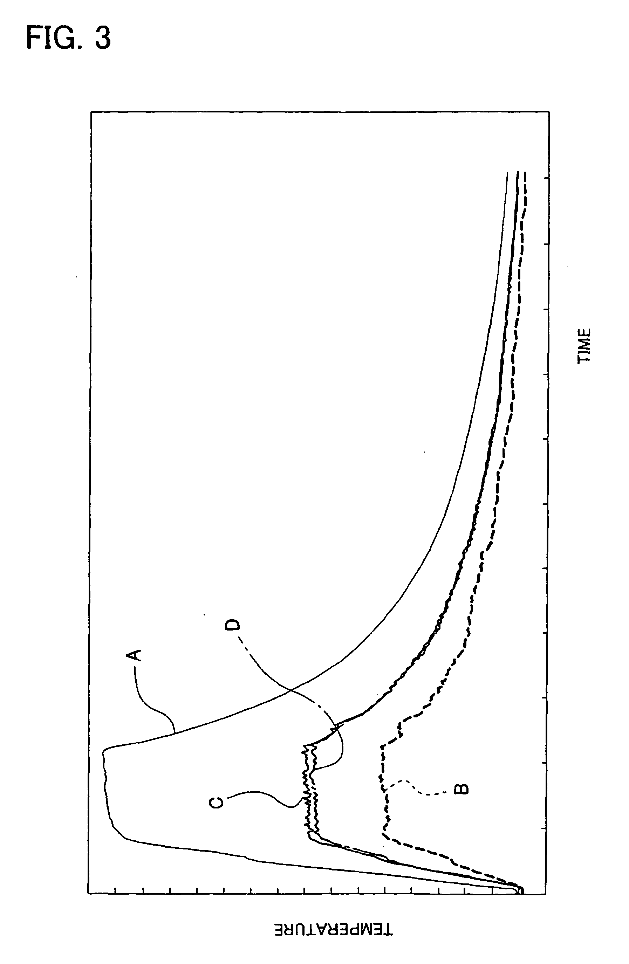

FIG. 3 is a diagram comparing the heat transfer characteristic of the general rubber material with that of the rubber material for use in the present device. In this diagram, several different rubber materials are laminated as the materials having the flexibility on the table whose temperature changes as shown by.a thin solid line A, and the temperature change of the upper surface of each of the rubber materials is shown. A bold broken line B shows the temperature change of the silicon rubber which is the general rubber material. A bold solid line C shows the temperature change of the rubber material of the silicon rubber mixed with 30% by weight of carbon whiskers as fine particles or fine fibers of carbon, and a bold one dot chain line D shows the temperature change of the rubber material whose mixture ratio of the carbon whiskers is set to 15%. The mixed carbon whiskers have a diameter of several tens to hundreds of nanometers, about 200 nm on average, and a ratio (1/d) of length to diameter is about 100.

As shown in Fig. 3, a rate of change (rise) of temperature for a material having a content of carbon whiskers of 15% or 30% is higher compared to a material which does not contain carbon whiskers. Thus, the time required for the material with carbon whiskers to reach a certain temperature is short, more specifically, about one half that for the material without carbon whiskers, and it is seen that the heat transfer characteristic is improved. Therefore, a time required for hardening the anisotropic conductive film can be shortened, for example, in mounting the circuit element, and productivity is enhanced.

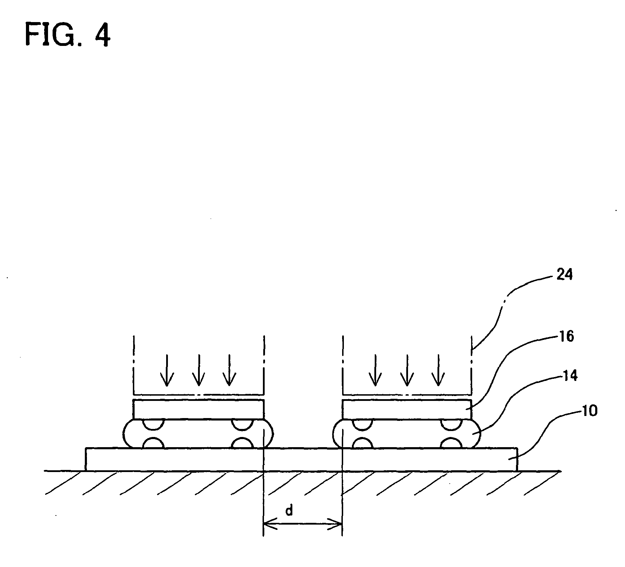

In accordance with a bonding method of the present embodiment, the integrally laid circuit element 16 and anisotropic conductive film 14 are pressed from the periphery, and therefore an amount of the anisotropic conductive film 14 protruding at the periphery can be reduced. For example, as shown in FIG. 4, when the circuit element 16 is pressed by a pressing rod 24 only from the upper surface, the anisotropic conductive film 14 protrudes at the periphery. An interval d between components to be mounted such as the adjacent circuit elements 16 needs to be set in consideration of the protruding amount, this has heretofore been one restriction, and the mounting density has not been increased. In accordance with the present embodiment, the protruding of the anisotropic conductive film 14 can be inhibited, the interval between the mounted components can be reduced, and the mounting density can be increased.

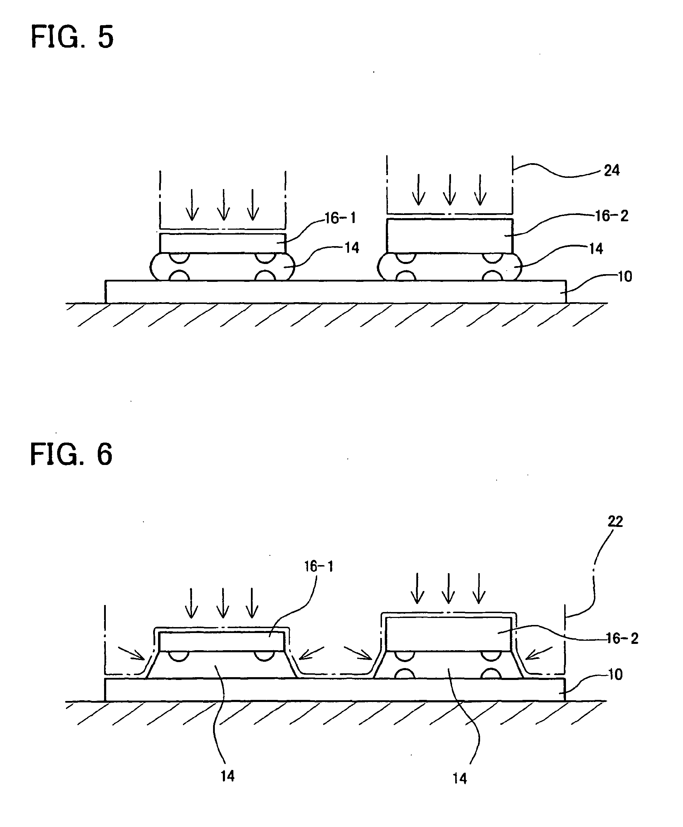

Moreover, a plurality of circuit elements having different thicknesses can be pressed simultaneously. As shown in FIG. 5, when circuit elements 16-1, 16-2 different in thickness are bonded, and pressed with a hard pressing mold, the pressure differs with each element, and it has heretofore been necessary to press and heat the elements one by one in order. However, in accordance with the present embodiment, as shown in FIG. 6, since the pressing mold has the flexible layer 22, a stepped portion caused by the thickness of the circuit element can be absorbed, and the bonding can be carried out with a substantially equal pressure. Accordingly, process time for the mounting can be significantly reduced.

Moreover, when the plurality of circuit elements 16 are heated and bonded one by one, the heat for the bonding is transferred to the pressure-unbonded circuit element in the vicinity of the circuit element being bonded and the anisotropic conductive film 14, and the anisotropic conductive film 14 is sometimes hardened before bonded. To prevent this, it has heretofore been necessary provide an interval between the circuit elements in order to prevent the adjacent circuit element or the like from being thermally influenced, and this has been one restriction preventing increase of the mounting density. In the present embodiment, since the plurality of circuit elements 16 can be heated/bonded simultaneously, this aspect also contributes towards an increase of the mounting density.

Moreover, the rubber material having a satisfactory heat transfer characteristic is used as the flexible layer of the pressing mold as described above. Therefore, when a faster temperature rise or drop is required in a pressing process such as a bonding process of the circuit element, the characteristics of the present device, namely that the thermal conductivity of the flexible material is satisfactory, are effective

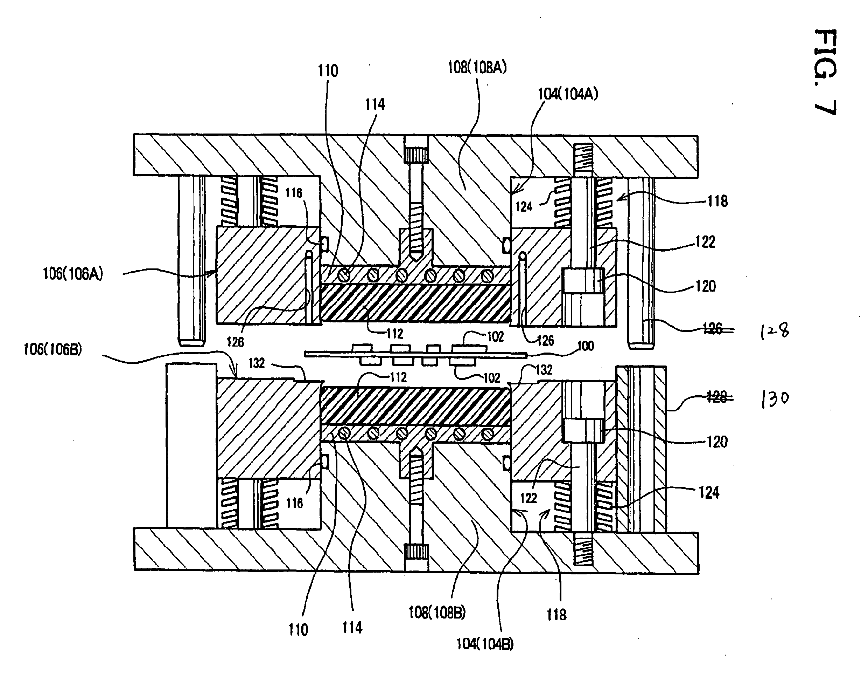

FIG. 7 is a diagram showing the schematic constitution of another example of the pressure device according to the present embodiment. This pressure device is a device suitable for mounting circuit elements 102 on the front and back surfaces of a substrate 100. Upper and lower constitutions via the substrate 100 are substantially symmetrical with respect to the substrate. In the following, the same upper and lower constituting elements are denoted with the same reference numerals, and A or B is added to each reference numeral for description, especially when these elements need to be distinguished.

The present device includes a pressing mold 104 which holds and presses the substrate 100 and circuit elements 102, and a side mold 106 positioned so as to surround the side of the pressing mold 104 and to support ends of the substrate 100. The pressing mold 104 includes a pressing mold main body 108 connected to the fluid pressure piston (not shown), and further heating plates 110 and pressing pads 112 are fixed to the tip of the pressing mold main body 108. The heating plates 110 are fixed to the pressing mold main body 108 by the pierced bolts. Heaters 114 are disposed inside. The temperature of the heating plates 110 rises due to the heating of the heaters 114, and the heat is transferred to the pressing objects via the pressing pads 112.

The pressing pads 112 are constituted of rubber plates having flexibility and elasticity, and are bonded/fixed to the heating plates 110. O rings 116 for mutually sealing the molds are disposed in the portions of the side surfaces of the pressing mold main bodies 108 which contact the side molds 106 in order to reduce the pressure in the cavity surrounded/formed by the upper/lower pressing molds 104 and side molds 106.

The pressing pads 112 function to absorb irregularity and to uniformly press overall in cases where the surfaces of the circuit elements 102 laid on the substrates 100 contacting the pads are not parallel to the substrate and where the thicknesses of the circuit elements 102 are not even and the like. That is, the pressing pads 112 function as the flexible layer to such an extent that the inclinations of the circuit elements 102 and the irregular thicknesses of the elements can be absorbed, that is, as the flexible layer 22 shown in FIG. 1. This flexible layer may be constituted of another flexible material instead of the rubber as long as the layer has required flexibility. In the present embodiment, the pads are constituted of silicon rubber, especially in consideration of the resistance to heat. A silicon rubber mixed with about 15 to 30% by weight of carbon whiskers described above may also be used.

The side molds 106 are suspended/supported from the pressing molds 104 by four support structures 118. The support structures 118 have stoppers 120 on the tips, and include guide rods 122 for guiding the side molds 106 in a vertical direction in the drawing, and springs 124 for urging the side molds 106 so that the side molds abut on the stoppers. Exhaust holes 126 for removing the gas from the space (cavity) surrounded with the molds are disposed in the upper side mold 106. A guide rod 128 is disposed in an upper pressing mold main body 108A, and a guide cylinder 130 in which the guide rod 128 is inserted is disposed in a lower pressing mold main body 108B in order to guide movements of upper/lower pressing molds 104A, 104B.

To mount the circuit elements 102, the anisotropic conductive films and circuit elements are superposed/disposed on the substrate 100 in the same manner as in the mounting only on one surface of the substrate as described above. The anisotropic conductive film is laid on the upper surface of the substrate 100, and further the circuit element is superposed/disposed. In this case, the circuit element is lightly pressed onto the anisotropic conductive film, and is provisionally bonded. The substrate 100 is turned over, and the circuit element is similarly provisionally bonded also on the other surface. Since the circuit element first laid on the substrate is provisionally bonded, the element does not drop off even when the substrate is turned over.

The substrate 100 is aligned with shoulder portions 132 disposed in the vicinity of the inner edges of a lower side mold 106B. Moreover, the upper/lower pressing molds 104A, 104B are moved in direction to approach each other. First, upper/lower side molds 106A, 106B abut. When the pressing molds 104A, 104B move closer, the side molds 106A, B relatively move on the guide rods 122, and the pressing by the pressing mold is prevented from being hindered. Moreover, the flexible pressing pads 112 hold/press the substrate 100 and circuit elements 102. The heating is simultaneously carried out by the heaters 114 to harden the above-described anisotropic conductive film, and the circuit elements 102 are mounted.

In accordance with the present device, the circuit elements can be mounted simultaneously on the front and back surfaces, and the man-hours required for the mounting can be reduced. In the same manner as in a case where the element is mounted only on one surface of the substrate as described above, the protruding of the anisotropic conductive film and the thermal influence on the non-pressure bonded element are prevented, and the mounting density can accordingly be increased.

In the above-described respective embodiments, the anisotropic conductive film is used to electrically connect the circuit element to the wiring on the substrate and to bond the circuit element onto the substrate, but a film for the bonding, which does not have a conductive function, may be used instead of the anisotropic conductive film in a case where only the bonding is performed. For example, a thermosetting resin film or the like can be used to mount the circuit element by heating and pressing.

## Claims

1. A method of mounting a circuit element (16) on a substrate (10), comprising:
a step of disposing an adhesive film (14) on the substrate (10), and superposing at least one circuit element (16) on the film (14); and
a step of pressing the circuit element (16) against the substrate (10) on the surface to be brought into contact with the element (16) by at least one upper mold (30) having a flexible layer (58), to bond the element (16) onto the substrate (10),
**characterized in that**
the step of pressing the circuit element (16) against the substrate (10) is performed within a cavity (36) formed by said upped mold (30), a lower mold (32) and a side mold (34) having an annular shape, such as to prevent lateral flow of the flexible layer during pressing.

2. The method of mounting the circuit element (16) according to claim 1, wherein:
the adhesive film (14) is a thermosetting resin film, and
heating is carried out simultaneously with the pressing to bond the circuit element (16) in the step of bonding the element (16) onto the substrate (10).

3. The method of mounting the circuit element (16) according to claim 1, wherein the adhesive film (14) is an anisotropic conductive film.

4. The method of mounting the circuit element (16) according to any one of claims 1 to 3, wherein the step of bonding the circuit element (16) onto the substrate is accomplished by performing an isotropic pressing operation in a state where the flexible layer is in close contact with the surface opposite to the pressing mold and the side surface of the integrally combined circuit element (16) and adhesive film (14).

5. The method of mounting the circuit element (16) according to any one of claims 1 to 4, wherein the step of bonding the circuit element (16) onto the substrate (10) is a step of simultaneously bonding the plurality of circuit elements (16).

6. The method of mounting the circuit element (16) according to any one of claims 1 to 5, wherein:
the step of disposing the circuit element (16) is a step of disposing the circuit elements (16) on the front and back surfaces of the substrate (10), and
the step of bonding the circuit element (16) is a step of disposing the pressing molds having the flexible layers with respect to the front and back surfaces of the substrate (10), and holding the substrate (10) together with the circuit elements (16) using these pressing molds to bond the circuit elements (16) onto the substrate (10).

7. The method of mounting the circuit element (16) according to any one of claims 1 to 6, wherein the flexible layer is a flexible base material which is mixed with a material for enhancing thermal conductivity of the flexible layer when added to the base material.

8. The method of mounting the circuit element (16) according to any one of claims 1 to 6, wherein the flexible layer is a base material of a flexible rubber which is mixed with fine particles or fine fibers of carbon.

9. The method of mounting the circuit element (16) according to claim 8, wherein carbon to be mixed with the base material is carbon whiskers.

10. The method of mounting the circuit element (16) according to claim 9, wherein a content of carbon whiskers in the flexible layer is in a range of 15 to 30% by weight.

11. The method of mounting the circuit element (16) according to claim 10, wherein the carbon whiskers have a diameter of 10 to 1000 nm, and a ratio of length to diameter of about 100.

## Patentansprüche

1. Verfahren zum Montieren eines Schaltungselementes (16) auf einem Substrat (10), aufweisend:
einen Schritt, bei dem ein Klebstofffilm (14) auf dem Substrat (10) angeordnet wird und darüber mindestens ein Schaltungselement (16) auf dem Film (14) angeordnet wird; und
einen Schritt, bei dem das Schaltungselement (16) gegen das Substrat (10) auf die Fläche gedrückt wird, die mit dem Element (16) in Kontakt gebracht werden soll, und zwar durch mindestens ein oberes Formwerkzeug (30), das einen flexible Schicht (58) aufweist, um das Element (16) durch Bonden auf das Substrat (10) aufzubringen,
**dadurch gekennzeichnet, dass**
der Schritt, bei dem das Schaltungselement (16) gegen das Substrat (10) gedrückt wird, innerhalb eines Hohlraums (36) durchgeführt wird, der durch das obere Formwerkzeug (30), ein unteres Formwerkzeug (32) und ein seitliches Formwerkzeug (34) gebildet wird, wobei dieser ringförmige Gestalt hat, derart, dass ein seitliches Fließen der flexiblen Schicht während des Pressens verhindert wird.

2. Verfahren zum Montieren des Schaltungselementes (16) nach Anspruch 1, bei dem der Klebstofffilm (14) ein wärmehärtender Harzfilm ist, und
ein Erwärmen gleichzeitig mit dem Pressen ausgeführt wird, um durch Bonden das Schaltungselement (16) bei dem Schritt aufzubringen, bei dem das Element (16) auf das Substrat (10) durch Bonden aufgebracht wird.

3. Verfahren zum Montieren des Schaltungselements (16) nach Anspruch 1, bei dem der Klebstofffilm (14) ein anisotrop leitender Film ist.

4. Verfahren zum Montieren des Schaltungselementes (16) nach einem der Ansprüche 1 bis 3, bei dem der Schritt, bei dem das Schaltungselement (16) durch Bonden auf das Substrat aufgebracht wird, **dadurch** bewerkstelligt wird, dass eine isotrope Pressoperation in einem Zustand durchgeführt wird, bei dem sich die flexible Schicht in engem Kontakt mit der Fläche gegenüberliegend zum Pressformwerkzeug und der Seitenfläche von integral kombinierten Schaltungselement (16) und Klebestofffilm (14) befindet.

5. Verfahren zum Montieren des Schaltungselementes (16) nach einem der Ansprüche 1 bis 4, bei dem der Schritt, bei dem das Schaltungselement (16) auf das Substrat (10) durch Bonden aufgebracht wird, ein Schritt ist, bei dem die Mehrzahl von Schaltungselementen (16) gleichzeitig durch Bonden aufgebracht werden.

6. Verfahren zum Montieren des Schaltungselements (16) nach einem der Ansprüche 1 bis 5, bei dem:
der Schritt, bei dem das Schaltungselement (16) angeordnet wird, ein Schritt ist, bei dem die Schaltungselemente (16) auf den Vorder- und Rückflächen des Substrates (10) angeordnet werden, und
der Schritt, bei dem das Schaltungselement (16) durch Bonden aufgebracht wird, ein Schritt ist, bei dem die die flexiblen Schichten aufweisenden Pressformwerkzeuge mit Bezug auf die Vorder- und Rückflächen des Substrates (10) angeordnet werden, und das Substrat (10) gemeinsam mit den Schaltungselementen (16) unter Verwendung dieser Pressformwerkzeuge gehalten wird, um die Schaltungselemente (16) durch Bonden auf das Substrat (10) aufzubringen.

7. Verfahren zum Montieren des Schaltungselementes (16) nach einem der Ansprüche 1 bis 6, bei dem die flexible Schicht ein flexibles Basismaterial ist, das mit einem Material vermischt ist, welches die Wärmeleitfähigkeit der flexiblen Schicht verbessert, wenn es dem Basismaterial zugesetzt ist.

8. Verfahren zum Montieren des Schaltungselementes (16) nach einem der Ansprüche 1 bis 6, bei dem die flexible Schicht ein Basismaterials aus einem flexiblen Gummi ist, der mit feinen Partikeln oder feinen Fasern aus Kohlenstoff vermischt ist.

9. Verfahren zum Montieren des Schaltungselementes (16) nach Anspruch 8, wobei es sich bei dem Kohlenstoff, der mit dem Basismaterial vermischt werden soll, um Kohlenstoff-Whisker handelt.

10. Verfahren zum Montieren des Schaltungselementes (16) nach Anspruch 9, bei dem der Gehalt an Kohlenstoff-Whiskern in der flexiblen Schicht zwischen 15 und 30 Gew.-% liegt.

11. Verfahren zum Montieren des Schaltungselementes (16) nach Anspruch 10, bei dem die Kohlenstoff-Whisker einen Durchmesser von 10 bis 1000 nm und ein Verhältnis von Länge zu Durchmesser von ca. 100 haben.

## Revendications

1. Procédé de montage d'un élément de circuit (16) sur un substrat (10), comprenant :
une étape de dépôt d'un film adhésif (14) sur le substrat (10), et de superposition d'au moins un élément de circuit (16) sur le film (14) ; et
une étape de pressage de l'élément de circuit (16) contre le substrat (10) sur la surface devant être amenée en contact avec l'élément (16) par au moins un moule supérieur (30) comportant une couche flexible (58) pour coller l'élément (16) sur le substrat (10),
**caractérisé en ce que**
l'étape de pressage de l'élément de circuit (16) contre le substrat (10) est réalisée dans une cavité (36) formée par ledit moule supérieur (30), un moule inférieur (32) et un moule latéral (34) ayant une forme annulaire, de façon à empêcher l'écoulement latéral de la couche flexible pendant le pressage.

2. Procédé de montage de l'élément de circuit (16) selon la revendication 1, dans lequel :
le film adhésif (14) est un film de résine thermodurcissable, et
le chauffage est réalisé simultanément avec le pressage pour coller l'élément de circuit (16) dans l'étape de collage de l'élément (16) sur le substrat (10).

3. Procédé de montage de l'élément de circuit (16) selon la revendication 1, dans lequel le film adhésif (14) est un film conducteur anisotrope.

4. Procédé de montage de l'élément de circuit (16) selon l'une quelconque des revendications 1 à 3, dans lequel l'étape de collage de l'élément de circuit (16) sur le substrat est réalisée en effectuant une opération de pressage isotrope dans un état dans lequel la couche flexible est en contact étroit avec la surface opposée au moule de pressage et la surface latérale de l'élément de circuit (16) et du film adhésif (14) intégralement combinés.

5. Procédé de montage de l'élément de circuit (16) selon l'une quelconque des revendications 1 à 4, dans lequel l'étape de collage de l'élément de circuit (16) sur le substrat (10) est une étape de collage simultané de la pluralité d'éléments de circuit (16).

6. Procédé de montage de l'élément de circuit (16) selon l'une quelconque des revendications 1 à 5, dans lequel :
l'étape de dépôt de l'élément de circuit (16) est une étape de dépôt des éléments de circuit (16) sur les surfaces avant et arrière du substrat (10), et
l'étape de collage de l'élément de circuit (16) est une étape de dépôt des moules de pressage comportant les couches flexibles par rapport aux surfaces avant et arrière du substrat (10), et de maintien du substrat (10) avec les éléments de circuit (16) en utilisant ces moules de pressage pour coller les éléments de circuit (16) sur le substrat (10).

7. Procédé de montage de l'élément de circuit (16) selon l'une quelconque des revendications 1 à 6, dans lequel la couche flexible est un matériau de base flexible mélangé avec un matériau pour améliorer la conductivité thermique de la couche flexible quand il est ajouté au matériau de base.

8. Procédé de montage de l'élément de circuit (16) selon l'une quelconque des revendications 1 à 6, dans lequel la couche flexible est un matériau de base de caoutchouc flexible mélangé avec des particules fines ou des fibres fines de carbone.

9. Procédé de montage de l'élément de circuit (16) selon la revendication 8, dans lequel le carbone devant être mélangé avec le matériau de base est constitué de trichites de carbone.

10. Procédé de montage de l'élément de circuit (16) selon la revendication 9, dans lequel la teneur en trichites de carbone dans la couche flexible est dans une plage allant de 15 à 30 % en poids.

11. Procédé de montage de l'élément de circuit (16) selon la revendication 10, dans lequel les trichites de carbone ont un diamètre allant de 10 à 1 000 nm, et un rapport de longueur sur diamètre d'environ 100.
